(19) Europäisches Patentamt
European Patent Office
Office européen des brevets

(11) **EP 4 618 133 A1**

(12) **EUROPEAN PATENT APPLICATION**
published in accordance with Art. 153(4) EPC

(43) Date of publication:
**17.09.2025 Bulletin 2025/38**

(21) Application number: 23888303.7

(22) Date of filing: **10.08.2023**

(51) International Patent Classification (IPC):
*H01L 21/02* ^(2006.01)   *B03C 3/40* ^(2006.01)
*B03C 3/47* ^(2006.01)   *B03C 3/60* ^(2006.01)
*B03C 3/66* ^(2006.01)   *B08B 6/00* ^(2006.01)
*B23Q 11/00* ^(2006.01)

(52) Cooperative Patent Classification (CPC):
**B03C 3/40; B03C 3/47; B03C 3/60; B03C 3/66;
B08B 6/00; B23Q 11/00; H01L 21/02**

(86) International application number:
**PCT/JP2023/029204**

(87) International publication number:
**WO 2024/100948 (16.05.2024 Gazette 2024/20)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **09.11.2022 JP 2022179220**

(71) Applicant: **CREATIVE TECHNOLOGY
CORPORATION
Kawasaki-shi, Kanagawa 213-0034 (JP)**

(72) Inventors:
• **HASEGAWA Takaaki**
  **Kawasaki-shi Kanagawa 213-0034 (JP)**
• **TATSUMI Yoshiaki**
  **Kawasaki-shi Kanagawa 213-0034 (JP)**
• **TENMA Yasuyuki**
  **Ootsu-shi Shiga 520-0843 (JP)**

(74) Representative: **Marks & Clerk LLP
15 Fetter Lane
London EC4A 1BW (GB)**

(54) **DUST COLLECTOR AND APPARATUS FOR PRODUCING SEMICONDUCTORS**

(57)    [Problem to be solved] To provide a dust collector that can be installed in a desired location without using a power generator and a fixing member.

[Solution] A dust collector 1A includes: a first electrode layer 12 formed of a material including a conductor; a second electrode layer 14 formed of a material including a conductor and disposed to face the first electrode layer 12; a first insulating layer 11 formed of a dielectric, disposed between the first electrode layer 12 and a fixed object S, and configured to insulate the first electrode layer 12 from the fixed object S; a second insulating layer 13 formed of a dielectric, disposed between the first electrode layer 12 and the second electrode layer 14, and configured to insulate the first electrode layer 12 from the second electrode layer 14; and a third insulating layer 15 disposed on a surface opposite to a surface of the second electrode layer 14 facing the fixed object S, and configured to insulate the second electrode layer 14.

[Figure 9]

EP 4 618 133 A1

**Description**

Technical Field

The present invention relates to a dust collector and a semiconductor manufacturing apparatus.

Background Art

For example, in a manufacturing site of a precise apparatus, a manufacturing site of a chemical substance requiring extremely high purity, or the like, it is necessary to keep a space within a manufacturing facility, such as a manufacturing apparatus, extremely strictly clean. In particular, extremely fine dust (hereinafter also referred to as particles) may have a fatal adverse effect on the quality of a product to be manufactured, and it is difficult to remove the particles from the space.

As a specific example, many of semiconductor manufacturing processes in the semiconductor manufacturing apparatus are performed in vacuum. However, even if the vacuum is created, all the particles in the manufacturing space are not discharged together with the air. As miniaturization of semiconductors to be manufactured progresses, the size of particles required to be removed becomes smaller.

These particles include particles generated by a chemical reaction in a semiconductor manufacturing apparatus, particles generated from a drive portion in the manufacturing apparatus, distortion of the apparatus due to a pressure difference, or the like, particles generated by expansion and contraction of the apparatus or a load lock chamber itself due to a pressure change of the load lock chamber in which a load lock for conveying a wafer to be processed is installed in a vacuum chamber in the manufacturing apparatus, or particles generated by particles being stirred up due to exhaust and air supply, and the like.

As a countermeasure against the particles, a slow vent that slows down the exhaust and the air supply, a dry nitrogen vent that expels gas containing particles from a chamber by feeding nitrogen gas into the chamber, or the like has been adopted in the related art, but it is actually difficult to remove extremely fine particles by these countermeasures.

In addition, since a power generator, which is a drive unit for circulating a gas, is a generation source of particles, a filter or an ionizer on the premise of circulating a gas cannot be used.

In this regard, the inventors have developed a dust collector that collects particles without including a drive unit (for example, Patent Literature 1).

However, with this technique alone, a fixing member is required to install the dust collector in a manufacturing chamber. Therefore, in a case where an adhesive is used as the fixing member, air bubbles remaining in the adhesive may expand when the pressure is reduced to a vacuum state, the dust collector may peel off from a fixed portion of the manufacturing chamber, and an undesirable substance such as a gas may be generated from the adhesive itself in a manufacturing process. When a fastening member such as magnets or bolts and nuts is used as the fixing member, particles may be generated from the fixing member itself.

Citation List

Patent Literature

Patent Literature 1: WO2022/064977

Summary of Invention

Technical Problem

An object of the present invention is to provide a dust collector that can be installed in a desired location without using a power generator and a fixing member.

The contents described in the above "Background Art" and "Technical Problem" indicate triggers that lead to the present invention, and do not limit the technical scope of the present invention, and do not allow limiting interpretation of the technical scope of the invention (see Heisei 17 (Gyo-Ke) No. 10042 and Patent Office Examination Guidelines, Part II, Chapter 2, Section 2, 3.2.1 as of the filing date.)

Solution to Problem

The present invention provides a dust collector including: a first electrode layer formed of a material including a conductor; a second electrode layer formed of a material including a conductor and disposed to face the first electrode layer; a first insulating layer formed of a dielectric, disposed between the first electrode layer and a fixed object, and configured to insulate the first electrode layer from the fixed object; a second insulating layer formed of a dielectric, disposed between the first electrode layer and the second electrode layer, and configured to insulate the first electrode layer from the second electrode layer; and a third insulating layer disposed on a surface opposite to a surface of the second electrode layer facing the fixed object, and configured to insulate the second electrode layer.

Advantageous Effects of Invention

According to the present invention, it is possible to provide a dust collector that can be installed in a desired location without using a power generator and a fixing member.

Brief Description of Drawings

[Figure 1] Figure 1 schematically illustrates an appearance of a dust collector according to a first embodiment.
[Figure 2] Figure 2 is a cross-sectional view of the dust collector according to the first embodiment taken along a line AA in Figure **1.**
[Figure 3] Figure 3 schematically illustrates an appearance of a dust collector according to a second embodiment.
[Figure 4] Figure 4 is a cross-sectional view of the dust collector according to the second embodiment taken along a line BB in Figure 3.
[Figure 5] Figure 5 is a plan view of each layer of the dust collector according to the second embodiment.
[Figure 6] Figure 6 is a cross-sectional view of the dust collector taken along the line BB in Figure 3, illustrating a state of an electric field generated in the dust collector according to the second embodiment.
[Figure 7] Figure 7 schematically illustrates an appearance of a dust collector according to a third embodiment.
[Figure 8] Figure 8 is a cross-sectional view of the dust collector according to the third embodiment taken along a line CC in Figure **7.**
[Figure 9] Figure 9 is a cross-sectional view of the dust collector taken along the line CC in Figure **7,** illustrating a state of an electric field generated in the dust collector according to the third embodiment.
[Figure 10] Figure 10 is an external perspective view of a power supply unit.
[Figure 11] Figure 11 is a cross-sectional view of the power supply unit taken along a line DD in Figure 10.
[Figure 12] Figure 12 is a cross-sectional view of the power supply unit taken along a line EE in Figure 10.
[Figure 13] Figure 13 is a cross-sectional view of the power supply unit taken along a line FF in Figure 10.
[Figure 14] Figure 14 illustrates a power transmission unit of a power supply unit according to an application example.
[Figure 15] Figure 15 is a schematic view of a semiconductor manufacturing apparatus including a dust collector.
[Figure 16] Figure 16 is an exploded perspective view of a feedthrough unit.
[Figure 17] Figure 17 illustrates a state in which installation of the feedthrough unit on a partition wall is completed.

Description of Embodiments

Hereinafter, a dust collector 1 according to an embodiment of the present invention will be described in detail with reference to the drawings. To summarize the dust collector 1, the dust collector 1 is a dust collector in which a layer on a rear surface side of the dust collector 1 is also provided with an adsorption performance by forming, using a dielectric, a layer closest to a fixed object S, which is a layer on a rear surface side of a dust collector (for example, the dust collector of Patent Literature 1) not using a conventional power generator, and the dust collector 1 can be installed on the fixed object by the adsorption performance.

(First Embodiment)

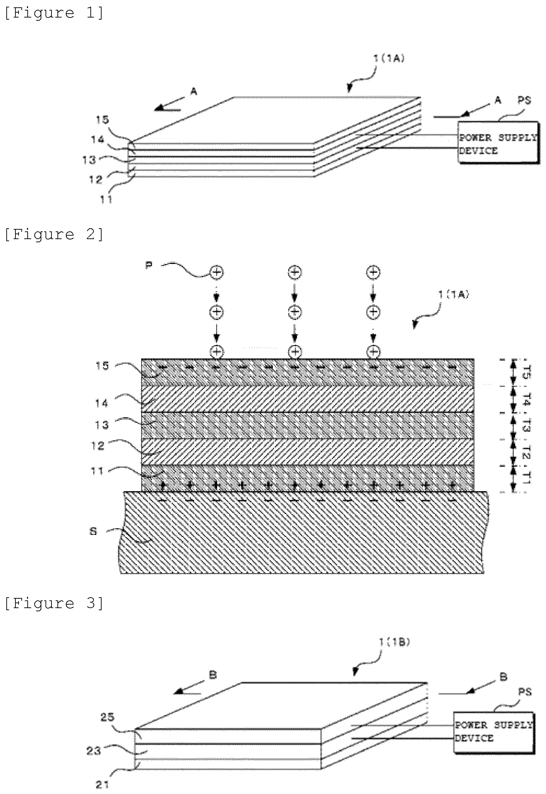

Figure 1 schematically illustrates an appearance of the dust collector 1 (hereinafter, also referred to as a dust collector 1A) according to a first embodiment of the present invention. Figure 2 is a cross-sectional view of the dust collector 1A taken along a line AA in Figure 1.
As illustrated in Figures 1 and 2, the dust collector 1A includes a first insulating layer 11, a first electrode layer 12, a second insulating layer 13, a second electrode layer 14, and a third insulating layer 15, which are laminated in this order from the fixed object S on which the dust collector 1A is installed.

(Shape and Thickness of Each Layer)

The first insulating layer 11, the first electrode layer 12, the second insulating layer 13, the second electrode layer 14, and the third insulating layer 15 have the same shape in a plan view.

The dust collector 1A can be formed into a single sheet by thinning each layer. A shape of the dust collector 1A in a plan view may be, for example, a square shape, but may be any shape depending on the circumstances such as an installation location.

As a thickness of each layer, the first insulating layer 11 has a thickness T1, the first electrode layer 12 has a thickness T2, the second insulating layer 13 has a thickness T3, the second electrode layer 14 has a thickness T4, and the third insulating layer 15 has a thickness T5.

The thickness T1 of the first insulating layer 11 is preferably 10 $\mu$m to 50 $\mu$m. Since the first insulating layer 11 functions as a dielectric layer of a so-called Coulomb type electrostatic chuck in the dust collector 1A, an adsorption force increases as the thickness T11 decreases, resulting in a trade-off with durability. The thickness T1 was 50 $\mu$m in Examples.

The thickness T2 of the first electrode layer 12 is preferably 5 $\mu$m to 100 $\mu$m. The thickness T2 of the first electrode layer 12 is preferably as small as possible because the first electrode layer 12 is softer and easier to handle and process. However, when the thickness T2 is too small, a defect such as wire breakage is likely to occur, and thus a better effect can be obtained by appropriately selecting the thickness T2 according to a manufacturing method and a material. The thickness T2 was 9 $\mu$m in Examples.

The thickness T3 of the second insulating layer 13 is preferably 25 $\mu$m to 300 $\mu$m. With respect to a potential difference between the first electrode layer 12 and the second electrode layer 14, the thickness T3 of the second insulating layer 13 is preferably, for example, about 10 um/potential difference of 1 kV in the case of polyimide having excellent insulation resistance from the viewpoint of durability or the like. However, since the first electrode layer 12 becomes harder when the thickness T2 is increased, a better effect can be obtained by setting the thickness T3 in consideration of the shape and size of the dust collector 1A to be implemented. When the thickness is too small, the withstand voltage performance is insufficient, resulting in a trade-off with the withstand voltage performance, ease of handling, and the like. The thickness T3 was 75 $\mu$m in Examples.

The thickness T4 of the second electrode layer 14 is preferably 5 $\mu$m to 100 $\mu$m. Similarly to the thickness T2 of the first electrode layer 12, when the thickness T4 of the second electrode layer 14 is set in consideration of the shape and size of the dust collector 1A to be implemented, a better effect can be obtained. The thickness T4 was 9 $\mu$m in Examples.

The thickness T5 of the third insulating layer 15 is preferably 50 $\mu$m to 1000 $\mu$m. The thickness T5 of the third insulating layer 15 can be set in consideration of durability because sufficient adsorption performance can be ensured even if the thickness T5 is increased to some extent. For example, even when the thickness T5 of the third insulating layer 15 was set to 500 um, there was almost no difference in dust collection performance as compared with the case where the thickness T5 was smaller than 500 $\mu$m. The thickness T5 was 50 $\mu$m in Examples. However, similarly to each of the first insulating layer 11, the first electrode layer 12, the second insulating layer 13, and the second electrode layer 14 described above, when the thickness T5 is increased, the ease of handling or the like is deteriorated. Therefore, when the thickness T5 is set in consideration of the shape and size of the dust collector 1A to be implemented, a better effect is obtained.

(Material of Insulating Layer)

The material of the first insulating layer 11 and the third insulating layer 15 is a so-called dielectric. The dielectric preferably has a sufficient dielectric breakdown strength with respect to the thickness set for each layer, and is desirably a dielectric having a volume resistivity of $10^{14}$ $\Omega \cdot$cm or more and a permittivity of 2F/m or more. The second insulating layer 13 may be an insulator, and preferably, has a sufficient dielectric breakdown strength with respect to the thickness set for each layer and has a volume resistivity of $10^{14}$ $\Omega \cdot$cm or more.

Here, an adsorption force of the dust collector 1 is considered to be the same force as a force (F) by which electrodes of a capacitor attract each other because the dust collector 1 is configured such that electrodes are insulated and laminated by a dielectric, and the relationship of the following formula (1) is established:

$$F = \varepsilon SV^2/2d^2 \quad (1)$$

where $\varepsilon$ is a permittivity, S is an area of an adsorption layer (the first insulating layer 11 and the third insulating layer 15) of the dust collector 1, V is a voltage, and d is a distance between the electrodes (a distance from the electrode to a surface of the adsorption layer, that is, a thickness of the adsorption layer).

Therefore, the permittivity $\varepsilon$ of the adsorption layer of the dust collector 1A, the thickness of the adsorption layer (the thickness T1 of the first insulating layer 11 and the thickness T5 of the third insulating layer 15), an applied voltage V, and the like can be determined with reference to the above formula (1).

When an adsorption force $F_d$ necessary for installation is set in consideration of a weight of the dust collector 1A, the adsorption force F needs to be larger than or equal to the adsorption force $F_d$. That is, when F is set to be larger than $F_d$ as much as possible, the dust collector 1A is stably fixed to the fixed object S.

Here, referring to the formula (1), in order to increase F, it is necessary to increase the permittivity $\varepsilon$ and the voltage V and reduce the thickness of the dielectric constituting the adsorption layer.

However, since the permittivity $\varepsilon$ is uniquely determined by the material, the voltage V is increased. However, when the applied voltage is increased, a thin dielectric layer may be broken by the voltage. Therefore, as the material of the dielectric constituting the adsorption layer, a material having a sufficient dielectric breakdown strength with respect to a necessary applied voltage is selected, the applied voltage being calculated based on the formula (1).

Examples of such a dielectric include polyimide. Since the polyimide has a permittivity $\varepsilon$ of about 3 F/m and dielectric breakdown strength of 400 kV/mm, it can be said that the polyimide has a sufficient dielectric breakdown strength even when the applied voltage is 2 kV and the thickness of the adsorption layer (the thickness T1 of the first insulating layer 11 and the thickness T5 of the third insulating layer 15) is 50 $\mu$m.

(Material and the like of Electrode Layer)

The material of the electrode layers (the first electrode layer 12 and the second electrode layer 14) is a conductor, and is preferably a material having a metal with low resistivity such as copper.

Examples of the material having a metal include a conductive film obtained by plating copper onto a film formed of a synthetic resin having a high insulating property such as polyimide. A thickness of a copper plating layer is, for example, 7 $\mu$m, and a thickness of a polyimide film provided with the plating layer is a thickness that is sufficient to support the copper plating layer and is convenient for processing and handling, for example, 10 $\mu$m.

The conductive film itself includes a synthetic resin layer having a high insulating property. Therefore, the insulating synthetic resin layer of the conductive film can directly serve as the first insulating layer 11, the second insulating layer 13, and the third insulating layer 15. That is, by employing the conductive film for the electrode layer, the number of layers laminated in the dust collector 1A can be reduced, which is advantageous when forming a conductive pattern in the dust collector 1A.

(Material of Fixed Object)

As the fixed object S, a solid is usually selected, but a substance other than a solid may be used as long as a shape thereof is maintained to some extent.

The fixed object S includes an insulator (including a dielectric), a conductor, or a semiconductor, and in particular, in the case of a substance having a volume resistivity of $10^{13}$ $\Omega$·cm or less, the dust collector 1A can be efficiently installed.

It should be noted that even an insulator of $10^{13}$ $\Omega$·cm or more becomes dielectric if a voltage is supplied to the dust collector 1A over a certain period of time, so that the dust collector 1A can be installed.

(Operation of Dust Collector of Present Embodiment)

When a higher reverse voltage is applied to one of the two electrode layers (the first electrode layer 12 and the second electrode layer 14) in the dust collector 1A compared to the other, the dielectric of the adsorption layer is induced, and a potential difference is generated on the surface. The adsorption layer of the dust collector 1A generates an adsorption force for substances (particles and fixed objects) having a potential opposite to the potential.

As illustrated in Figure 2, for example, when a voltage of 2 kV is applied to the first electrode layer 12 and a voltage of -4 kV, which is a reverse voltage higher than the voltage applied to the first electrode layer 12, is applied to the second electrode layer 14, an adsorption surface of the first insulating layer 11 (a surface of the first insulating layer 11 facing the fixed object S) becomes positively polarized (+), and an adsorption surface of the third insulating layer 15 (a surface opposite to a surface of the third insulating layer 15 facing the fixed object S, that is, a surface on which particles P are adsorbed) becomes negatively polarized (-).

Therefore, the positively (+) charged particles P are attracted to the adsorption surface of the third insulating layer 15 and collected. Since a surface of the fixed object S becomes negatively polarized (-) by contact with the adsorption surface of the first insulating layer 11, the dust collector 1A can be installed on the fixed object S.

(Effects of First Embodiment)

As described above, the dust collector 1A of the present embodiment includes: the first electrode layer 12 formed of a material including a conductor; the second electrode layer 14 formed of a material including a conductor and disposed to face the first electrode layer 12; the first insulating layer 11 formed of a dielectric, disposed between the first electrode layer 12 and the fixed object S, and configured to insulate the first electrode layer 12 from the fixed object S; the second insulating layer 13 formed of a dielectric, disposed between the first electrode layer 12 and the second electrode layer 14, and configured to insulate the first electrode layer 12 from the second electrode layer 14; and the third insulating layer 15 disposed on a surface opposite to a surface of the second electrode layer 14 facing the fixed object S, and configured to insulate the second electrode layer 14.

Therefore, according to the present embodiment, it is possible to provide the dust collector 1A that can be installed in a desired location without using a power generator and a fixing member.

(Second Embodiment)

A dust collector 1B of the second embodiment is different from the dust collector 1A of the first embodiment in that each layer has substantially the same shape, but the second electrode layer 24 has a penetrating portion 24P penetrating therethrough in a thickness direction and has a sufficient size to cover the first electrode layer 22 in a plan view.

Since the dust collector 1B of the second embodiment has the above configuration, an electric field becomes non-uniform near the penetrating portion 24P of the adsorption surface of the third insulating layer 25 (the surface opposite to the surface of the third insulating layer 25 facing the fixed object S, that is, the surface on which the particles P are adsorbed), and only a part of the third insulating layer 15 formed of a dielectric is polarized to generate a gradient force.

Therefore, not only charged particles P but also non-charged particles P such as ceramics and glass can be attracted and collected in a direction of the adsorption surface by the gradient force.

(Shape and Thickness of Each Layer)

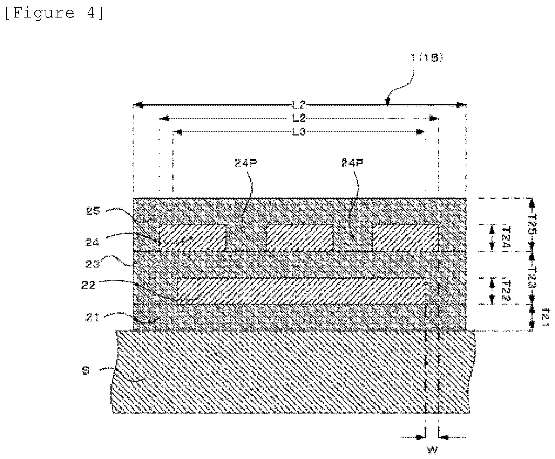

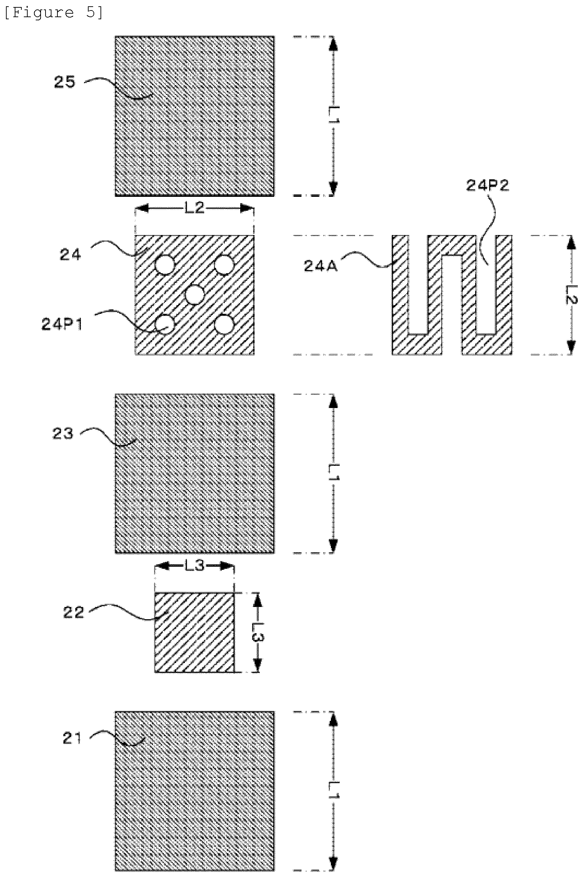

Figure 3 schematically illustrates an appearance of the dust collector 1 (hereinafter, also referred to as a dust collector 1B) according to the second embodiment. Figure 4 is a cross-sectional view of the dust collector 1B taken along a line BB in Figure **3.** Figure 5 is a plan view of each layer of the dust collector 1B.

As illustrated in Figures 3 and 5, the dust collector 1B includes a first insulating layer 21, a first electrode layer 22, a second insulating layer 23, a second electrode layer 24, and a third insulating layer 25, which are laminated in this order from a fixed object S on which the dust collector 1B is installed.

The dust collector 1B can be formed into a single sheet by thinning each layer. A shape of the dust collector 1B in a plan view may be, for example, a square shape, but may be any shape depending on the circumstances such as an installation location. Hereinafter, an example in which the dust collector 1B is formed in a square shape will be described.

The first insulating layer 21, the second insulating layer 23, and the third insulating layer 25 are formed to have approximately the same square shape and size in the plan view in which each side has a length L1.

The second electrode layer 24 is formed to have a square shape in which each side has a length L2 smaller than the length L1. The first electrode layer 22 is formed to have a square shape in which each side has a length L3 smaller than the length L2.

The electric field is concentrated at each of corners serving as vertices of the square shapes of the first electrode layer 22 and the second electrode layer 24, and the first electrode layer 22 and the second electrode layer 24 are likely to be damaged. This damage may cause a failure of the dust collector 1B itself. Therefore, the corners serving as the vertices of the square shapes of the first electrode layer 22 and the second electrode layer 24 are preferably rounded.

Therefore, in a plan view seen from the adsorption surface side, the first electrode layer 22 fits within the second electrode layer 24, and the second electrode layer 24 fits within the first insulating layer 21, the second insulating layer 23, and the third insulating layer 25.

As illustrated in Figure 4, the first electrode layer 22 is formed such that edges of the first electrode layer 22 are located on an inner side by a width W or more from edges of the second electrode layer 24. The width W is, for example, 5 mm or more.

The thickness of each layer of the dust collector 1B of the second embodiment is in the same range as the thickness of each corresponding layer of the dust collector 1A of the first embodiment, and the thickness in Examples of each layer of the dust collector 1B of the second embodiment was the same as the thickness in Examples of each corresponding layer of the dust collector 1A of the first embodiment.

As illustrated in Figure 5, in a plan view, the first insulating layer 21, the first electrode layer 22, the second insulating layer 23, and the third insulating layer 25 do not have the penetrating portion 24P, and are each formed as a layered sheet or a layered plate.

On the other hand, the second electrode layer 24 has circular through holes 24P1 at equal intervals and penetrating therethrough in the thickness direction as the penetrating portion 24P. An inner diameter of each of the through holes 24P1 is, for example, 5 mm to 15 mm, and an interval between adjacent through holes 24P1 is 10 mm to 30 mm.

A second electrode layer 24A according to a modification of the second electrode layer 24 has a slit 24P2 as the penetrating portion 24P.

The penetrating portion 24P is provided so as not to hinder energization to the second electrode layer **24.**

(Material of Insulating Layer)

The materials of the first insulating layer 21, the second insulating layer 23, and the third insulating layer 25 of the dust collector 1B of the second embodiment may be the same as the materials of the first insulating layer 11, the second insulating layer 13, and the third insulating layer 15 of the dust collector 1A of the first embodiment.

(Material and the like of Electrode Layer)

The materials of the first electrode layer 22 and the second electrode layer 24 of the dust collector 1B of the second embodiment may be the same as the materials of the first electrode layer 12 and the second electrode layer 14 of the dust collector 1A of the first embodiment.

(Material of Fixed Object)

The fixed object S on which the dust collector 1B of the second embodiment is installed is the same as the fixed object S on which the dust collector 1A of the first embodiment is installed.

(Operation of Dust Collector of Present Embodiment)

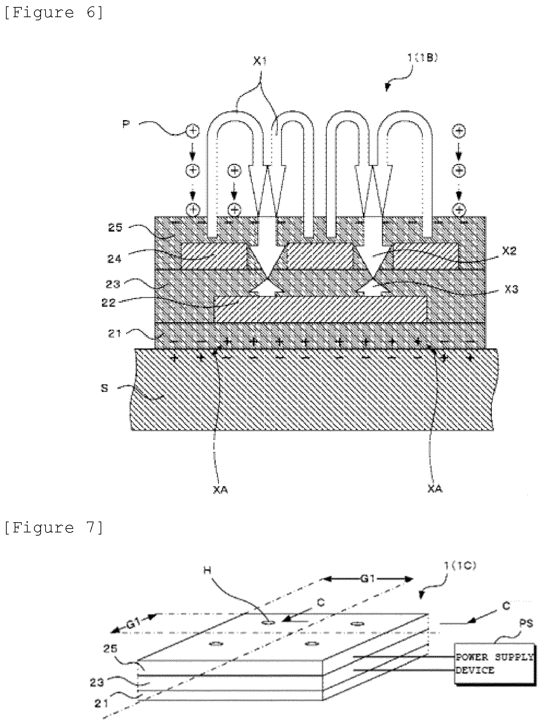

Figure 6 is a cross-sectional view of the dust collector 1B taken along the line BB in Figure 3, illustrating a state of an electric field generated in the dust collector 1B. In Figure 6, white arrows X1, X2, and X3 indicate electric fields.

As illustrated in Figure 6, for example, when a voltage of 2 kV is applied to the first electrode layer 22 and a voltage of -4 kV, which is a reverse voltage higher than the voltage applied to the first electrode layer 22, is applied to the second electrode layer 24, in an adsorption surface of the first insulating layer 21 (a surface of the first insulating layer 21 facing the fixed object S), a portion where the first electrode layer 22 is provided becomes positively polarized (+), and a portion where the first electrode layer 22 is not provided becomes negatively polarized (-).

When the surface of the fixed object S comes into contact with the adsorption surface of the first insulating layer 21, a portion thereof where the first insulating layer 21 becomes positively polarized (+) becomes negatively polarized (-) and a portion thereof where the first insulating layer 21 becomes negatively polarized (-) becomes positively polarized (+), and thus the dust collector 1B can be installed on the fixed object S.

Further, as indicated by an arrow XA, a boundary between polarized areas on the adsorption surface of the first insulating layer 21 is a boundary between polarized areas on the fixed object S, and a polarity of an area of the adsorption surface of the first insulating layer 21 where the first electrode layer 22 is installed is the same as a polarity of an area of the fixed object S that does not face the first insulating layer 21. Therefore, even if the dust collector 1B attempts to move along the surface of the fixed object S, the movement is suppressed by a repulsive force between like polarities, and an installation position of the dust collector 1B can be prevented from shifting.

On the other hand, the adsorption surface of the third insulating layer 25 (the surface opposite to the surface of the first insulating layer 21 facing the fixed object S, that is, the surface on which the particles P are adsorbed) becomes negatively polarized (-).

The electric field passes the third insulating layer 25 from the second electrode layer 24, reaches a space where the particles P exist, passes the third insulating layer 25 again, passes the second insulating layer 23 through the penetrating portion 24P of the second electrode layer 24, and reaches the first electrode layer 22.

Therefore, an unbalanced electric field is generated in an outward direction of the third insulating layer 25 of the dust collector 1B, the particles P are repelled from a workpiece or the like by the outward electric field, and the particles are moved along the electric field by an inward electric field and adsorbed onto the third insulating layer 25.

Here, the second electrode layer 24 covers the entire surface of the first electrode layer 22 in a plan view. Therefore, all orientations of the electric field from the second electrode layer 24 are aligned in the direction of the penetrating portion 24P, that is, an inner direction of the dust collector 1B in the plan view, and thus, it is possible to prevent particles from scattering to an outer side of the dust collector 1B.

In addition, the electric field becomes non-uniform near the penetrating portion 24P of the adsorption surface of the third insulating layer 25, and only a part of the third insulating layer 25 formed of a dielectric is polarized to generate a gradient force.

Therefore, in a case where the particles P are made of a conductor or some insulating material, the particles P are charged inside the electric field due to electrostatic induction, and in a case where the particles P are made of an insulating material or a semiconductor, the particles P are charged inside the electric field due to dielectric polarization. The particles P are charged in both cases.

The charged particles P are carried by the electric field and adsorbed onto the third insulating layer 25.

(Effects of Second Embodiment)

As described above, the dust collector 1B of the present embodiment includes: the first electrode layer 22 formed of a material including a conductor; the second electrode layer 24 formed of a material including a conductor, disposed to face the first electrode layer 22, having the penetrating portion 24P penetrating therethrough in the thickness direction, and having a sufficient size to cover the first electrode layer 22 in a plan view; the first insulating layer 11 formed of a dielectric, disposed between the first electrode layer 22 and the fixed object S, and configured to insulate the first electrode layer 22 from the fixed object S; the second insulating layer 23 formed of a dielectric, disposed between the first electrode layer 22 and the second electrode layer 24, and configured to insulate the first electrode layer 22 from the second electrode layer 24; and the third insulating layer 25 disposed on a surface opposite to a surface of the second electrode layer 24 facing the fixed object S, and configured to insulate the second electrode layer 24.

Therefore, according to the present embodiment, it is possible to provide the dust collector 1A that can be installed at a desired location without using a power generator and a fixing member, it is possible to attract and collect the uncharged particles P such as ceramics and glass in the direction of the adsorption surface by the gradient force, and it is possible to prevent the installation position of the dust collector 1B from shifting.

(Third Embodiment)

The dust collector 1B of the second embodiment differs from the dust collector 1A of the first embodiment in that the second electrode layer 24 has the penetrating portion 24P penetrating therethrough in a thickness direction and has a sufficient size to cover the first electrode layer 22 in a plan view, but both remain flat in the plan view. Meanwhile, a dust collector 1C of the third embodiment differs from the dust collector 1A and the dust collector 1B in that the dust collector 1C further has a communicating through hole H that allows the first insulating layer 21, the second insulating layer 23, and the third insulating layer 25 to communicate.

Since the dust collector 1C of the third embodiment has the above configuration, in a case where the surface roughness of the surface of the fixed object S is small when the surface of the fixed object S is made of polished metal or ceramics, a gas such as air sealed between the adsorption surface of the first insulating layer 21 of the dust collector 1C and the surface of the fixed object S passes through the communicating through hole H, and even in a case where the periphery of the dust collector 1C is in a vacuum state, the dust collector 1C does not peel off from the surface of the fixed object S due to expansion of the sealed gas.

(Shape and Thickness of Each Layer)

The shape and thickness of each layer of the dust collector 1C of the third embodiment are the same as the shape and thickness of each layer of the dust collector 1B of the second embodiment.

(Regarding Communicating Through Hole)

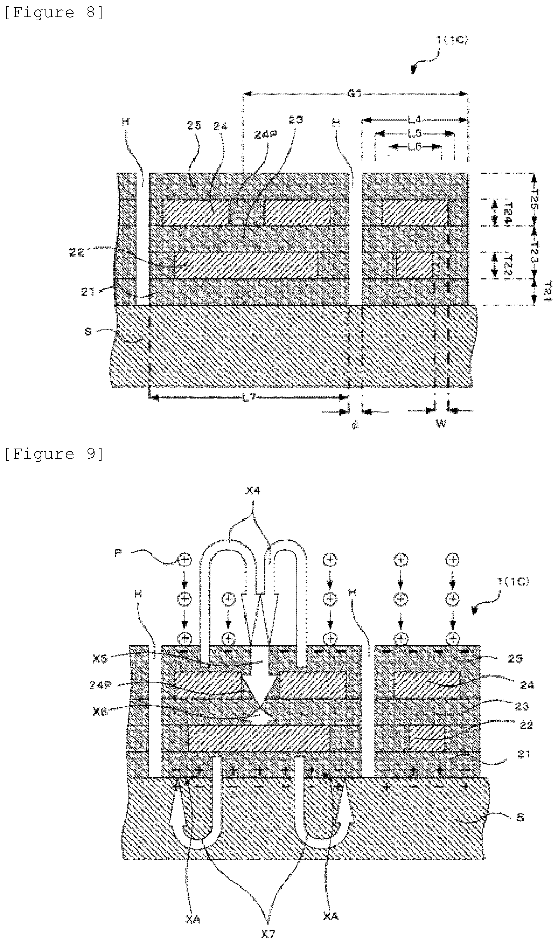

Figure 7 schematically illustrates an appearance of the dust collector (hereinafter, also referred to as the dust collector 1C) according to the third embodiment. Figure 8 is a cross-sectional view of the dust collector 1C taken along a line CC in Figure 7.

As illustrated in Figures 7 and 8, the dust collector 1C of the third embodiment further includes, in addition to the configuration of the dust collector 1B of the second embodiment, the communicating through hole H that allows all layers from the first insulating layer 21 to the third insulating layer 25 to communicate.

The communicating through hole H is disposed at a position where the first electrode layer 22 and the second electrode layer 24 are not exposed to an internal space of the communicating through hole H.

In a plan view of the dust collector 1C, communicating through holes H are arranged one by one in one square of a lattice formed by arranging squares each having a side length G1 without a gap. As an example of a specific installation density of the communicating through holes H, one communicating through hole H is provided in a square having a length G1 of 5 cm, and a distance L7 between the communicating through holes H is 30 mm.

An example of an inner diameter $\varphi$ of the communicating through hole H is 0.5 mm or more and the length L7 or less. The inner diameter $\varphi$ of the communicating through hole H in Examples was 0.8 mm.

The communicating through hole H is advantageous for installation and fixing in that the larger the installation density, the higher the effect of releasing the gas such as air sealed between the adsorption surface of the first insulating layer 21 of the dust collector 1C and the surface of the fixed object **S.** However, when the installation density is increased, an area of the adsorption surface of the third insulating layer 25 decreases, and a dust collection effect decreases. Therefore, the installation density of the communicating through holes H has a trade-off relationship between an installation and fixing performance and the dust collection effect.

(Material of Insulating Layer)

The materials of the first insulating layer 21, the second insulating layer 23, and the third insulating layer 25 of the dust collector 1C of the third embodiment may be the same as the materials of the first insulating layer 11, the second insulating layer 13, and the third insulating layer 15 of the dust collector 1A of the first embodiment.

(Material and the like of Electrode Layer)

The materials of the first electrode layer 22 and the second electrode layer 24 of the dust collector 1C of the third embodiment may be the same as the materials of the first electrode layer 12 and the second electrode layer 14 of the dust collector 1A of the first embodiment.

(Material of Fixed Object)

The fixed object S on which the dust collector 1C of the third embodiment is installed is the same as the fixed object S on which the dust collector 1B of the second embodiment is installed.

(Operation of Dust Collector of Present Embodiment)

The operation of the dust collector 1C of the third embodiment is the same as the operation of the dust collector 1B of the second embodiment.

Figure 9 is a cross-sectional view of the dust collector 1C taken along the line CC in Figure 7, illustrating a state of an electric field generated in the dust collector 1C. In Figure 9, white arrows X4, X5, X6, and X7 indicate electric fields.

As illustrated in Figure 9, similarly to the dust collector 1B of the second embodiment, the dust collector 1C can be installed on the fixed object S, an installation position of the dust collector 1C can be prevented from shifting, and not only charged particles P but also non-charged particles P can be attracted and collected in the direction of the adsorption surface by the gradient force.

However, the provision of the communicating through hole H may reduce the dust collection effect. Therefore, the inventors have confirmed by the following experiment that the dust collector 1C can sufficiently obtain the installation and fixing performance and the dust collection effect even when the communicating through hole H is provided.

(Experiment)

<Protocol>

1. The shape and size of the dust collector 1C used in the experiment: a cuboid of 100 mm x 370 mm (a film with a rectangular shape in a plan view).

2. Experimental Conditions

Temperature 24°C, humidity 55%, and under atmospheric pressure
The dust collector 1C was installed such that each adsorption surface was perpendicular to a horizontal plane.
A voltage of 2 kV was applied to the first electrode layer 12, and a voltage of -4 kV was applied to the second electrode layer 14.

3. Material of Fixed Object

First fixed object: stainless steel (conductor, earthed) Second fixed object: stainless steel (conductor, not earthed)
Third fixed object: polyvinyl chloride (insulator)

4. Substitute Sample of Particles P

Rectangular aluminum foil having a size of 10 mm × 0.5 mm and a thickness of 12 μm suspended by a thread

5. Experimental Procedure

(1) Whether the dust collector 1C could be fixed to each fixed object S was checked.
(2) A maximum distance at which the sample was adsorbed to the dust collector 1C was measured.
(3) The dust collector 1C was adsorbed and fixed to the first fixed object, and the applied voltage was changed to measure a change in the maximum distance at which the sample was adsorbed by the dust collector 1C.

<Results>

(1) Whether the dust collector 1C could be fixed to each fixed object S was checked.

First fixed object: stainless steel (conductor, earthed): firmly fixed
Second fixed object: stainless steel (conductor, without ground): firmly fixed
Third fixed object: polyvinyl chloride (insulator): firmly fixed

(2) Measurement results of the maximum distance at which the sample was adsorbed to the dust collector 1C

First fixed object: stainless steel (conductor, earthed): 65 mm

Second fixed object: stainless steel (conductor, not earthed): 75 mm

Third fixed object: polyvinyl chloride (insulator): 70 mm

(3) The dust collector 1C was adsorbed and fixed to the first fixed object, and the applied voltage was changed to measure a change in the maximum distance at which the sample was adsorbed by the dust collector 1C.

[Table 1]

| Second electrode (KV) | First electrode (KV) | Distance (mm) | Potential difference | Distance/Potential difference |
|---|---|---|---|---|
| -10 | 2 | 120 | 12 | 10.0 |
| -9 | 2 | 110 | 11 | 10.0 |
| -8 | 2 | 105 | 10 | 10.5 |
| -7 | 2 | 100 | 9 | 11.1 |
| -6 | 2 | 95 | 8 | 11.9 |
| -5 | 2 | 85 | 7 | 12.1 |
| -4 | 2 | 70 | 6 | 11.7 |
| -3 | 2 | 55 | 5 | 11.0 |

[Table 2]

| Second electrode (KV) | First electrode (KV) | Distance (mm) | Potential difference | Distance/Potential difference |
|---|---|---|---|---|
| -10 | 1 | 110 | 11 | 10.0 |
| -9 | 1 | 105 | 10 | 10.5 |
| -8 | 1 | 100 | 9 | 11.1 |

(continued)

| Second electrode (KV) | First electrode (KV) | Distance (mm) | Potential difference | Distance/Potential difference |
|---|---|---|---|---|
| -7 | 1 | 95 | 8 | 11.9 |
| -6 | 1 | 85 | 7 | 12.1 |
| -5 | 1 | 80 | 6 | 13.3 |
| -4 | 1 | 65 | 5 | 13.0 |
| -3 | 1 | 50 | 4 | 12.5 |

<Conclusion>

It was confirmed by the following experiment that the dust collector 1C can sufficiently obtain the installation and fixing performance and the dust collection effect even when the communicating through hole H is provided.

(Effects of Third Embodiment)

As described above, the dust collector 1C of the present embodiment includes: the first electrode layer 22 formed of a material including a conductor; the second electrode layer 24 formed of a material including a conductor, disposed to face the first electrode layer 22, having the penetrating portion 24P penetrating therethrough in the thickness direction, and having a sufficient size to cover the first electrode layer 22 in a plan view; the first insulating layer 11 having a communicating through hole H (a first communicating through hole) that penetrates therethrough in the thickness direction and is disposed such that the first electrode layer 22 and the second electrode layer 24 are not exposed to an inside thereof, formed of a dielectric, disposed between the first electrode layer 22 and the fixed object S, and configured to insulate the first electrode layer 22 from the fixed object S; the second insulating layer 23 having a communicating through hole H (a second communicating through hole) that penetrates therethrough in the thickness direction, is disposed such that the first electrode layer 22 and the second electrode layer 24 are not exposed to an inside thereof, and communicates with the communicating through hole H of the first insulating layer 11, formed of a dielectric, disposed between the first electrode layer 22 and the second electrode layer 24, and configured to insulate the first electrode layer 22 from the second electrode layer 24; and the third insulating layer 25 formed of a dielectric, having a communicating through hole H (a third communicating through hole) that communicates with the communicating through hole H of the second insulating layer 23 and penetrates therethrough in the thickness direction, disposed on a surface opposite to a surface of the second electrode layer 24 facing the fixed object S, and configured to insulate the second electrode layer 24.

Therefore, according to the present embodiment, it is possible to provide the dust collector 1A that can be installed at a desired location without using a power generator and a fixing member, it is possible to attract and collect the uncharged particles P such as ceramics and glass in the direction of the adsorption surface by the gradient force, it is possible to prevent the installation position of the dust collector 1B from shifting, and the dust collector 1C is prevented from being peeled off from the surface of the fixed object S due to expansion of a gas such as air sealed between the adsorption surface of the first insulating layer 21 of the dust collector 1C and the surface of the fixed object **S.**

(Fourth Embodiment)

The dust collector 1 of the present embodiment includes the dust collector 1 selected from one type of dust collector 1A to 1C of the first to third embodiments, and a power supply unit 30 that is connected to the first electrode layer 12 and the second electrode layer 14, or the first electrode layer 22 and the second electrode layer 24 (hereinafter, the first electrode layer 12, the second electrode layer 14, the first electrode layer 22, and the second electrode layer 24 are collectively referred to as the "electrode layer") of the dust collector 1 and supplies power to the electrode layer. The power supply unit 30 includes a power transmission unit 30A and a connection unit 30B.

As described above, the dust collector 1 can be formed to have a smaller thickness (a height from an installation surface to an upper end of the dust collector 1) than conventional dust collectors in order to increase installation location flexibility. However, even if the thickness of the dust collector 1 is reduced, when a structure for supplying power to the dust collector 1 becomes bulky, the installation location flexibility is also limited.

Therefore, the power supply unit 30 of the present embodiment includes the film-like power transmission unit 30A and the connection unit 30B including a thermosetting conductive bonding film.

Therefore, the structure for supplying power to the dust collector 1 is not bulky, and the installation location flexibility of the dust collector 1 is not impaired.

(Power Supply Unit)

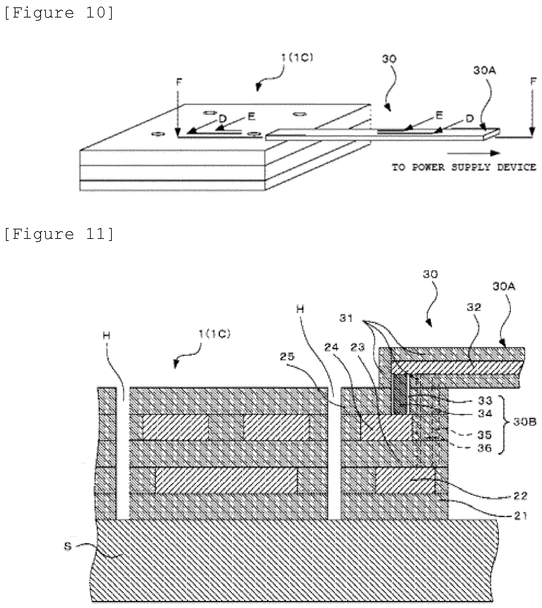

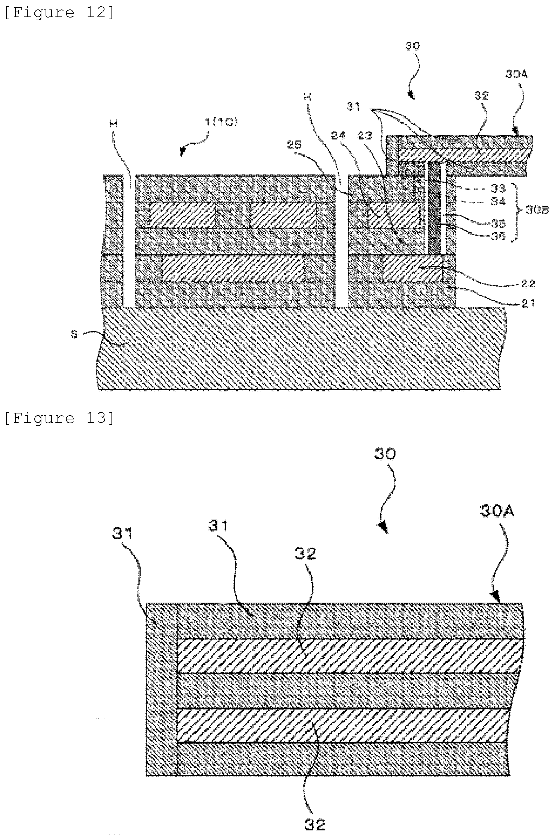

Figure 10 is an external perspective view of the power supply unit 30. Figure 11 is a cross-sectional view of the power supply unit 30 taken along a line DD in Figure 10. Figure 12 is a cross-sectional view of the power supply unit 30 taken along a line EE in Figure 10. Figure 13 is a cross-sectional view of the power supply unit 30 taken along a line FF in Figure 10.

As illustrated in Figures 10 to 13, the power supply unit 30 of the present embodiment includes the power transmission unit 30A that is connected to the electrode layer of the dust collector 1 and supplies power to the electrode layer, and a connection unit 30B that connects the electrode layer and the power transmission unit 30A.

(Power Transmission Unit)

The power transmission unit 30A of the present embodiment includes a pair of power transmission layers 32 that are formed of a conductive film and transmit power, and a covering layer 31 that is formed of a dielectric, and covers and insulates the pair of power transmission layers 32 (hereinafter also referred to as a first power transmission layer and a second power transmission layer).

As the covering layer 31, a dielectric used for each insulating layer of the dust collector 1 can be used. A thickness of the covering layer 31 can be set using, for example, the above formula (1).

The thickness of the covering layer 31 can be substantially equal to the thickness T1 of the first insulating layer 11, and specifically, can be 10 $\mu$m to 50 $\mu$m. The thickness of the covering layer 31 is, for example, 13 $\mu$m.

A width of the covering layer 31 can be set to a sufficient width to insulate the power transmission layer 32.

As the conductive film used for the power transmission layer 32, a material used for the electrode layer of the dust collector 1 can be used. As the conductive film, a film-like material formed of a thermosetting conductive resin such as a thermosetting conductive bonding film can be used.

The thermosetting conductive resin can be generated, for example, by mixing conductor powder with an acrylic resin or an epoxy resin.

As the thermosetting conductive bonding film, a plurality of products have already been marketed, and examples thereof include CBF (registered trademark) series manufactured by Tatsuta Electric Wire Co., Ltd.

A thickness of the power transmission layer 32 is 20 $\mu$m to 50 $\mu$m. A width of the power transmission layer 32 is set according to a magnitude of power to be transmitted. The thickness of the power transmission layer 32 is, for example, 22 $\mu$m.

The power transmission unit 30A can be generated by laying the covering layer 31 as a lowermost layer, laminating the power transmission layer 32 on the covering layer 31, further laminating the covering layer 31 thereon, and crimping these layers while heating to about 180°C.

According to the above example, the thickness of the power transmission unit 30A can be suppressed to 150 $\mu$m or less.

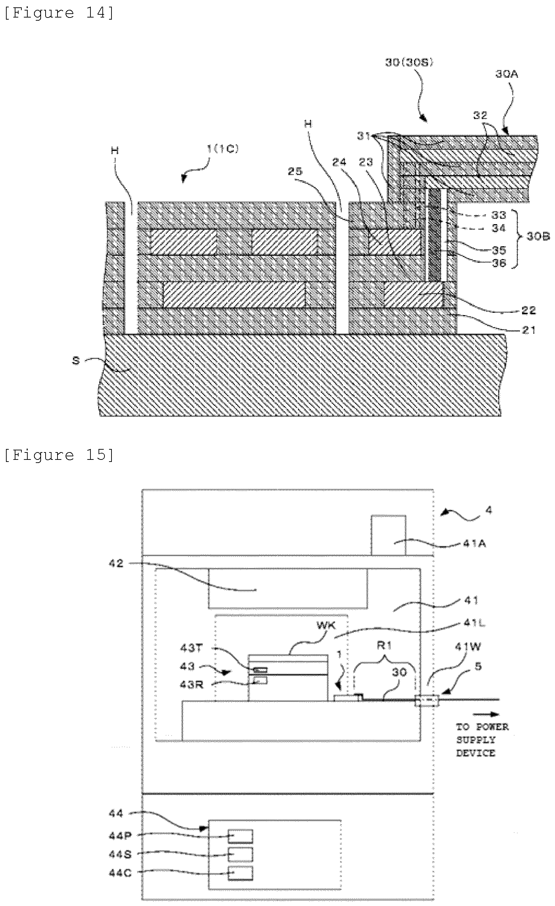

Figure 14 illustrates the power transmission unit 30A of a power supply unit 30S according to an application example. Figure 14 is a cross-sectional view of the power supply unit 30S taken along the line DD in Figure 10.

As illustrated in Figure 14, the power transmission unit 30A may include a first power transmission layer and a second power transmission layer arranged side by side in the thickness direction, and a covering layer 31 that is formed of a dielectric, and covers and insulates the first power transmission layer and the second power transmission layer.

In this case, the power transmission unit 30A has the same configuration as that of the dust collector 1, and areas near opposing surfaces of the covering layers 31 laminated from above and below become dielectrically polarized when energized, and an adsorption force is generated on a surface of the covering layers 31 like an electrostatic chuck, and thus the power transmission unit 30A is adsorbed onto the fixed object **S.**

Therefore, the power transmission unit 30A can be fixed to the fixed object S without using a fixing member. This effect cannot be achieved with ordinary electric wires.

(Connection Unit)

The connection unit 30B includes a first connection conductor 34 that is provided in a first connection conductor installation hole 33, which is a hole provided from the third insulating layer (the third insulating layer 15 and the third insulating layer 25) toward the second electrode layer (the second electrode layer 14 and the second electrode layer 24) of the dust collector 1, and connects one power transmission layer 32 of the pair of power transmission layers and the first electrode layer, and a second connection conductor 36 that is provided in a second connection conductor installation hole 35, which is a hole provided from the third insulating layer toward the first electrode layer (the first electrode layer 12 and the first electrode layer 22) of the dust collector 1, and connects the other power transmission layer 32 and the first electrode layer.

The first connection conductor 34 and the second connection conductor 36 can be made of the same material as the material of the power transmission layer 32, specifically, a thermosetting conductive bonding film or a thermosetting conductive liquid resin.

The connection unit 30B can be formed by laminating layers separately from the power transmission unit 30A or simultaneously with the power transmission unit 30A at the time of manufacturing the dust collector 1 and crimping these layers while heating to about 180°C.

(Effects of Fourth Embodiment)

As described above, the dust collector 1 of the present embodiment includes the power supply unit 30 including the power transmission unit 30A and the connection unit 30B.

The power transmission unit 30A includes the first power transmission layer that is formed of a conductive film, is connected to the first electrode layer, and supplies power to the first electrode layer, the second power transmission layer that is formed of a conductive film, is connected to the second electrode layer, and supplies power to the second electrode layer, and the covering layer 31 that is formed of a dielectric, covers and insulates the first power transmission layer and the second power transmission layer.

The power transmission unit 30A includes the first power transmission layer and the second power transmission layer arranged side by side in the thickness direction, and the covering layer 31 that is formed of a dielectric, and covers and insulates the first power transmission layer and the second power transmission layer.

Therefore, the power transmission unit 30A has the following effects.

(1) The thickness of the power transmission unit 30A can be reduced, and the installation location flexibility of the dust collector 1 is not impaired.

(2) When the power transmission unit 30A includes the first power transmission layer and the second power transmission layer arranged side by side in the thickness direction, and the covering layer 31 that is formed of a dielectric, and covers and insulates the first power transmission layer and the second power transmission layer, the power transmission unit 30A has the same configuration as that of the dust collector **1,** and the areas near opposing surfaces of the covering layers 31 laminated from above and below become dielectrically polarized when energized, and thus the power transmission unit 30A is adsorbed onto the fixed object S.

Therefore, the power transmission unit 30A can be fixed to the fixed object S without using a fixing member.

In addition, the connection unit 30B includes the first connection conductor installation hole 33 that is a hole provided from the third insulating layer toward the second electrode layer, the first connection conductor 34 that is provided in the first connection conductor installation hole 33 and connects one power transmission layer 32 of the pair of power transmission layers and the first electrode layer, the second connection conductor installation hole 35 that is a hole provided from the third insulating layer toward the first electrode layer of the dust collector 1, and the second connection conductor 36 that is provided in the second connection conductor installation hole 35 and connects the other power transmission layer 32 and the second electrode layer.

Therefore, a thickness of a connection portion of the connection unit 30B can be reduced, and the installation location flexibility of the dust collector 1 is not impaired.

(Fifth Embodiment)

The dust collector 1 according to the first to fourth embodiments can be installed in an apparatus or the like for processing a workpiece in a gas, or can be installed in an apparatus for processing a workpiece such as a silicon wafer in a vacuum such as a semiconductor manufacturing apparatus. Hereinafter, a semiconductor manufacturing apparatus 4 in which the dust collector 1 according to the first to fourth embodiments is installed will be described.

(Semiconductor Manufacturing Apparatus)

Figure 15 is a schematic view of the semiconductor manufacturing apparatus 4 including the dust collector 1. As illustrated in Figure 15, the semiconductor manufacturing apparatus 4 includes a vacuum chamber 41 that accommodates a workpiece WK, an electrostatic chuck device 43 that is accommodated in the vacuum chamber 41 and adsorbs and fixes the workpiece WK, a processing device 42 that performs processing such as plasma etching on the workpiece WK fixed to the electrostatic chuck device 43, the dust collector 1 selected from the first to fourth embodiments, which is installed near the electrostatic chuck device 43, the power supply unit 30 that supplies power to the dust collector 1, a feedthrough unit 5 that draws the power supply unit 30 from an inside of the vacuum chamber 41 to an atmospheric environment through a partition wall 41W, and a control device 44 that controls each device included in the semiconductor manufacturing apparatus **4.**

Further, the semiconductor manufacturing apparatus 4 may further include a load lock device 41L that loads and unloads the workpiece WK into and from the vacuum chamber 41 while keeping the workpiece WK clean.

The dust collector 1 collects the particles P inside the vacuum chamber 41 and keeps the inside of the vacuum chamber 41 clean.

The electrostatic chuck device 43 may further include an identification tag 43T incorporated in a replaceable consumable portion of the electrostatic chuck device 43, and a reader/writer 43R that is installed in a support portion to which the consumable portion is attached and reads and writes the identification tag 43T.

The control device 44 includes a control unit 44P having a computing device such as a central processing unit (CPU), a storage unit 44S having a storage device such as a hard disk drive and a memory, and a communication unit 44C that communicates with various devices installed in the semiconductor manufacturing apparatus 4 and devices outside the semiconductor manufacturing apparatus 4 via a public communication network such as the Internet.

The dust collector 1 is always ON and continues to collect the particles P inside the vacuum chamber 41. Therefore, since the dust collector 1 is constantly supplied with power, the dust collector 1 does not shift or is not displaced from the installation position.

Before operating the electrostatic chuck device 43, the control unit 44P reads an identification code from the identification tag 43T of the consumable portion by the reader/writer 43R, and reads a permission list which is a list of identification codes permitted to be connected and is stored in the storage unit 44S in advance.

The control unit 44P determines whether the read identification code is included in the permission list.

The control unit 44P permits the semiconductor manufacturing apparatus 4 to perform a processing operation only when it is determined that the read identification code is included in the permission list.

When the processing operation is permitted, the control unit 44P determines whether the inside of the vacuum chamber 41 is in a desired vacuum state, and performs a subsequent processing operation when it is determined that the inside of the vacuum chamber 41 is in the desired vacuum state.

The control unit 44P operates the load lock device 41L to place the workpiece WK on the electrostatic chuck device 43, and activates the electrostatic chuck device 43 to fix the workpiece WK.

The control unit 44P causes the processing device 42 to process the workpiece WK.

(Feedthrough Unit)

In a case where the semiconductor manufacturing apparatus 4 is an apparatus that processes the workpiece WK with a processing chamber in a vacuum state, the semiconductor manufacturing apparatus 4 includes the feedthrough unit 5 that draws the power supply unit 30 from the inside of the vacuum chamber 41 to the atmospheric environment through the partition wall 41W.

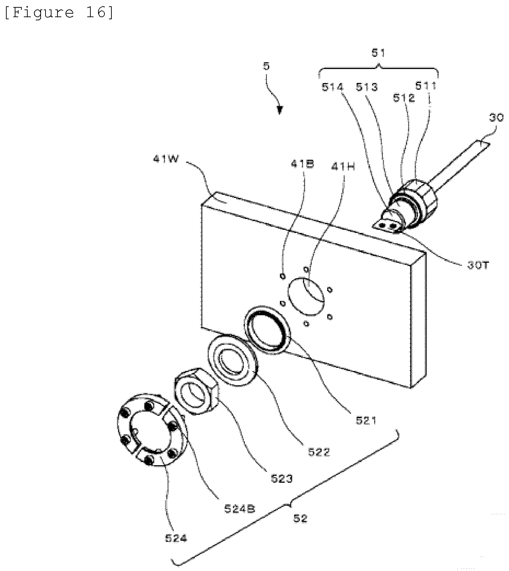

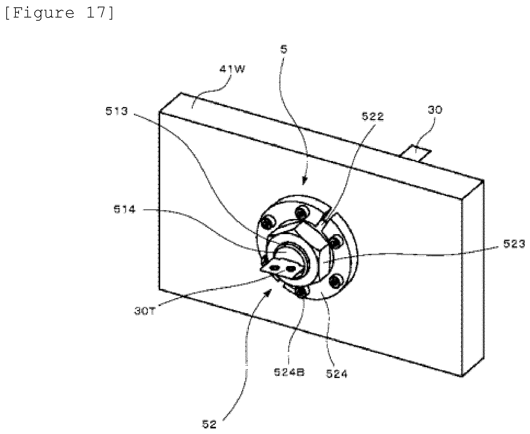

Figure 16 is an exploded perspective view of the feedthrough unit 5. Figure 17 illustrates a state in which installation of the feedthrough unit 5 on the partition wall 41W is completed.

As illustrated in Figures 16 and 17, the feedthrough unit 5 installed in the vacuum chamber 41 of the semiconductor manufacturing apparatus 4 includes a power supply end gripping portion 51 that is attached immediately before an end 30T of the power supply unit 30 inside the vacuum chamber 41, and a fixing portion 52 that is provided to penetrate the partition wall 41W of the vacuum chamber 41 and hermetically fixes, to the partition wall 41W, the end 30T of the power supply unit 30 inserted through an insertion hole 41H through which the end 30T of the power supply unit 30 is inserted.

The power supply end gripping portion 51 includes: a threaded portion 513 having a tubular shape in which the power supply unit 30 is tightly fixed inside while exposing the end 30T by a sealing fixing portion 514 and an outer periphery of a tip end thereof is threaded; a gripping flange portion 511 having a larger outer diameter than the threaded portion 513 and a flat end surface; and a sealing ring 512 installed on the end surface of the gripping flange portion 511 and formed of an elastomer such as rubber.

The fixing portion 52 includes: a sealing portion 521 formed in a ring shape, having an annular sealing pad formed of an elastomer on the partition wall 41W side, and formed of a material having rigidity such as metal; a pressure washer 522 that presses the sealing portion 521 toward the partition wall 41W; a nut 523 attached to a thread of the threaded portion 513 of the power supply end gripping portion 51; and a fastening portion 524 fastened to a bolt hole 41B provided in the partition wall 41W by a bolt 524B.

The power supply end gripping portion 51 tightly fixes the power supply unit 30 to an inside of the tubular gripping flange portion 511 by the sealing fixing portion 514, and thus prevents outside air from leaking from the inside of the tubular gripping flange portion 511 to the inside of the vacuum chamber 41.

Here, for example, one or more materials selected from the following materials can be used for the sealing fixing portion 514.

·Epoxy Resin
·Silicone Resin
·Polyacetal
·Polybutylene terephthalate
·Polycarbonate

When the nut 523 is tightened, the fixing portion 52 draws the power supply end gripping portion 51 toward the partition wall 41W so that the sealing ring 512 is pressed against the partition wall 41W. Therefore, the sealing ring 512 prevents the outside air from entering the inside of the vacuum chamber 41 from the insertion hole 41H.

Further, when the nut 523 of the fixing portion 52 is tightened, the nut 523 presses the sealing portion 521 against the partition wall 41W via the pressure washer 522. Therefore, the sealing portion 521 prevents the outside air from entering the inside of the vacuum chamber 41 from the insertion hole 41H.

(Effects of Fifth Embodiment)

As described above, the semiconductor manufacturing apparatus 4 includes the dust collector 1 according to the first to fourth embodiments inside the vacuum chamber 41 that accommodates the workpiece WK.

Therefore, the semiconductor manufacturing apparatus 4 of the present embodiment has an effect that the inside of the vacuum chamber 41 can be kept in an extremely clean state.

In addition, the semiconductor manufacturing apparatus 4 of the present embodiment includes a feedthrough mechanism including the power supply end gripping portion 51 and the fixing portion 52. The power supply end gripping portion 51 includes: the sealing fixing portion 514 that is formed in a tubular shape, and tightly fixes the power supply unit 30 to the inside of the threaded portion 513 while exposing the end 30T; the threaded portion 513 having a threaded outer periphery at the tip end; the gripping flange portion 511 having a larger outer diameter than the threaded portion 513 and a flat end surface; and the sealing ring 512 installed on the end surface of the gripping flange portion 511 and formed of an elastomer such as rubber. The fixing portion 52 includes: the sealing portion 521 formed in a ring shape, having an annular sealing pad formed of an elastomer on the partition wall 41W side, the partition wall 41W partitioning an inside and an outside of the vacuum chamber 41, and formed of a material having rigidity such as metal; the pressure washer 522 that presses the sealing portion 521 toward the partition wall 41W; the nut 523 attached to a thread of the threaded portion 513 of the power supply end gripping portion 51; and the fastening portion 524 fastened to the bolt hole 41B provided in the partition wall 41W by the bolt 524B.

Therefore, the semiconductor manufacturing apparatus 4 of the present embodiment has an effect that the power supply unit 30 can be drawn out from the inside of the vacuum chamber 41 to the atmospheric environment through the partition wall 41W while maintaining the inside of the vacuum chamber 41 in a vacuum even if the power supply unit 30 has a thin film shape.

(Industrial Applicability)

The dust collector 1, the power supply unit 30, and the feedthrough unit 5 of each embodiment of the present invention can be applied not only to an apparatus for processing a workpiece in a vacuum state but also to an environment where the atmosphere is extremely thin, such as space.

Reference Signs List

1 dust collector
1A dust collector
1B dust collector
1C dust collector
4 semiconductor manufacturing apparatus
5 feedthrough unit
11 first insulating layer
12 first electrode layer
13 second insulating layer
14 second electrode layer
15 third insulating layer
21 first insulating layer

22 first electrode layer
23 second insulating layer
24 second electrode layer
24A second electrode layer
24P penetrating portion
24P1 through hole
24P2 slit
25 third insulating layer
30 power supply unit
30A power transmission unit
30B connection unit
30S power supply unit
30T end
31 covering layer
32 power transmission layer
33 first connection conductor installation hole
34 first connection conductor
35 second connection conductor installation hole
36 second connection conductor
41 vacuum chamber
41B bolt hole
41H insertion hole
41L load lock device
41W partition wall
42 processing device
43 electrostatic chuck device
43R reader/writer
43T identification tag
44 control device
44C communication unit
44P control unit
44S storage unit
51 power supply end gripping portion
52 fixing portion
511 gripping flange portion
512 sealing ring
513 threaded portion
514 sealing fixing portion
521 sealing portion
522 pressure washer
523 nut
524 fastening portion
524B bolt

**Claims**

1. A dust collector comprising:

   a first electrode layer formed of a material including a conductor;
   a second electrode layer formed of a material including a conductor and disposed to face the first electrode layer;
   a first insulating layer formed of a dielectric, disposed between the first electrode layer and a fixed object, and configured to insulate the first electrode layer from the fixed object;
   a second insulating layer formed of a dielectric or an insulator, disposed between the first electrode layer and the second electrode layer, and configured to insulate the first electrode layer from the second electrode layer; and
   a third insulating layer disposed on a surface opposite to a surface of the second electrode layer facing the fixed object, and configured to insulate the second electrode layer.

2. A dust collector comprising:

a first electrode layer formed of a material including a conductor;

a second electrode layer formed of a material including a conductor, disposed to face the first electrode layer, having a penetrating portion penetrating therethrough in a thickness direction, and having a sufficient size to cover the first electrode layer in a plan view;

a first insulating layer formed of a dielectric, disposed between the first electrode layer and a fixed object, and configured to insulate the first electrode layer from the fixed object;

a second insulating layer formed of a dielectric or an insulator, disposed between the first electrode layer and the second electrode layer, and configured to insulate the first electrode layer from the second electrode layer; and

a third insulating layer disposed on a surface opposite to a surface of the second electrode layer facing the fixed object, and configured to insulate the second electrode layer.

3. A dust collector comprising:

a first electrode layer formed of a material including a conductor;

a second electrode layer formed of a material including a conductor, disposed to face the first electrode layer, having a penetrating portion penetrating therethrough in a thickness direction, and having a sufficient size to cover the first electrode layer in a plan view;

a first insulating layer having a first communicating through hole that penetrates therethrough in the thickness direction and is disposed such that the first electrode layer and the second electrode layer are not exposed to an inside thereof, formed of a dielectric, disposed between the first electrode layer and the fixed object, and configured to insulate the first electrode layer from the fixed object;

a second insulating layer having a second communicating through hole that penetrates therethrough in the thickness direction, is disposed such that the first electrode layer and the second electrode layer are not exposed to an inside thereof, and communicates with the first communicating through hole of the first insulating layer, formed of a dielectric or an insulator, disposed between the first electrode layer and the second electrode layer, and configured to insulate the first electrode layer from the second electrode layer; and

a third insulating layer formed of a dielectric, having a third communicating through hole that communicates with the second communicating through hole of the second insulating layer and penetrates therethrough in the thickness direction, disposed on a surface opposite to a surface of the second electrode layer facing the fixed object, and configured to insulate the second electrode layer.

4. The dust collector according to any one of claims 1 to 3, further comprising:
a power supply unit including a power transmission unit, the power transmission unit including:

a first power transmission layer formed of a conductive film and connected to the first electrode layer to supply power to the first electrode layer;

a second power transmission layer formed of a conductive film and connected to the second electrode layer to supply power to the second electrode layer; and

a covering layer formed of a dielectric and configured to cover and insulate the first power transmission layer and the second power transmission layer.

5. The dust collector according to claim 4, wherein
the first power transmission layer and the second power transmission layer of the power transmission unit are arranged side by side in the thickness direction.

6. The dust collector according to claim 5, wherein
the power supply unit further includes a connection unit, the connection unit including:

a first connection conductor provided in a first connection conductor installation hole that is a hole provided from the third insulating layer toward the first electrode layer, and configured to connect one of the power transmission layers and the first electrode layer; and

a second connection conductor provided in a second connection conductor installation hole that is a hole provided from the third insulating layer toward the second electrode layer, and configured to connect the other of the power transmission layers and the second electrode layer.

7. A semiconductor manufacturing apparatus comprising:

a vacuum chamber configured to accommodate a workpiece;

an electrostatic chuck device accommodated in the vacuum chamber and configured to adsorb and fix the workpiece;

a processing device configured to perform processing on the workpiece fixed to the electrostatic chuck device; and

the dust collector according to any one of claims 1 to 3, which is installed near the electrostatic chuck device.

8. A semiconductor manufacturing apparatus comprising the dust collector according to claim 4.

9. A semiconductor manufacturing apparatus comprising the dust collector according to claim 5.

10. A semiconductor manufacturing apparatus comprising:
a feedthrough mechanism including a power supply end gripping portion and a fixing portion, the power supply end gripping portion including:

a threaded portion formed in a tubular shape and having a threaded outer periphery at the tip end;
a sealing fixing portion configured to tightly fix a power supply unit to an inside of the threaded portion while exposing an end thereof;
a gripping flange portion having an outer diameter larger than that of the threaded portion and a flat end surface; and
a sealing ring provided on the end surface of the gripping flange portion and formed of an elastomer, and
the fixing portion including:

a sealing portion formed in a ring shape, having an annular sealing pad formed of an elastomer on a side of a partition wall that partitions an inside and an outside of a vacuum chamber, and formed of a material having rigidity;
a pressure washer configured to press the sealing portion toward the partition wall;
a nut attached to a thread of the threaded portion of the power supply end gripping portion; and
a fastening portion fastened to a bolt hole provided in the partition wall by a bolt.

**Amended claims under Art. 19.1 PCT**

1. (Canceled)

2. (Canceled)

3. A dust collector comprising:

a first electrode layer formed of a material including a conductor;
a second electrode layer formed of a material including a conductor, disposed to face the first electrode layer, having a penetrating portion penetrating therethrough in a thickness direction, and having a sufficient size to cover the first electrode layer in a plan view;
a first insulating layer having a first communicating through hole that penetrates therethrough in the thickness direction and is disposed such that the first electrode layer and the second electrode layer are not exposed to an inside thereof, formed of a dielectric, disposed between the first electrode layer and the fixed object, and configured to insulate the first electrode layer from the fixed object;
a second insulating layer having a second communicating through hole that penetrates therethrough in the thickness direction, is disposed such that the first electrode layer and the second electrode layer are not exposed to an inside thereof, and communicates with the first communicating through hole of the first insulating layer, formed of a dielectric or an insulator, disposed between the first electrode layer and the second electrode layer, and configured to insulate the first electrode layer from the second electrode layer; and
a third insulating layer formed of a dielectric, having a third communicating through hole that communicates with the second communicating through hole of the second insulating layer and penetrates therethrough in the thickness direction, disposed on a surface opposite to a surface of the second electrode layer facing the fixed object, and configured to insulate the second electrode layer.

4. (Amended) The dust collector according to claim 3, further comprising:
a power supply unit including a power transmission unit, the power transmission unit including:

a first power transmission layer formed of a conductive film and connected to the first electrode layer to supply power to the first electrode layer;

a second power transmission layer formed of a conductive film and connected to the second electrode layer to supply power to the second electrode layer; and

a covering layer formed of a dielectric and configured to cover and insulate the first power transmission layer and the second power transmission layer.

5. The dust collector according to claim 4, wherein
the first power transmission layer and the second power transmission layer of the power transmission unit are arranged side by side in the thickness direction.

6. The dust collector according to claim 5, wherein
the power supply unit further includes a connection unit, the connection unit including:

a first connection conductor provided in a first connection conductor installation hole that is a hole provided from the third insulating layer toward the first electrode layer, and configured to connect one of the power transmission layers and the first electrode layer; and

a second connection conductor provided in a second connection conductor installation hole that is a hole provided from the third insulating layer toward the second electrode layer, and configured to connect the other of the power transmission layers and the second electrode layer.

7. (Amended) A semiconductor manufacturing apparatus comprising:

a vacuum chamber configured to accommodate a workpiece;

an electrostatic chuck device accommodated in the vacuum chamber and configured to adsorb and fix the workpiece;

a processing device configured to perform processing on the workpiece fixed to the electrostatic chuck device; and

the dust collector according to claim 3, which is installed near the electrostatic chuck device.

8. A semiconductor manufacturing apparatus comprising the dust collector according to claim 4.

9. A semiconductor manufacturing apparatus comprising the dust collector according to claim 5.

10. A semiconductor manufacturing apparatus comprising:
a feedthrough mechanism including a power supply end gripping portion and a fixing portion, the power supply end gripping portion including:

a threaded portion formed in a tubular shape and having a threaded outer periphery at the tip end;

a sealing fixing portion configured to tightly fix a power supply unit to an inside of the threaded portion while exposing an end thereof;

a gripping flange portion having an outer diameter larger than that of the threaded portion and a flat end surface; and

a sealing ring provided on the end surface of the gripping flange portion and formed of an elastomer, and the fixing portion including:

a sealing portion formed in a ring shape, having an annular sealing pad formed of an elastomer on a side of a partition wall that partitions an inside and an outside of a vacuum chamber, and formed of a material having rigidity;

a pressure washer configured to press the sealing portion toward the partition wall;

a nut attached to a thread of the threaded portion of the power supply end gripping portion; and

a fastening portion fastened to a bolt hole provided in the partition wall by a bolt.

**Statement under Art. 19.1 PCT**

[0001]    Claims 1 and 2 are cancelled. Claims 4 and 7 have been amended to depend solely from Claim 3. Claims 3, 5, 6, and 8 to 10 remain unchanged

[Figure 1]

[Figure 2]

[Figure 3]

[Figure 4]

[Figure 5]

[Figure 6]

[Figure 7]

[Figure 8]

[Figure 9]

[Figure 10]

TO POWER SUPPLY DEVICE

[Figure 11]

[Figure 12]

[Figure 13]

[Figure 14]

[Figure 15]

[Figure 16]

[Figure 17]

# INTERNATIONAL SEARCH REPORT

| International application No. |
|---|
| **PCT/JP2023/029204** |

| A. | CLASSIFICATION OF SUBJECT MATTER |
|---|---|

*H01L 21/02*(2006.01)i; *B03C 3/40*(2006.01)i; *B03C 3/47*(2006.01)i; *B03C 3/60*(2006.01)i; *B03C 3/66*(2006.01)i; *B08B 6/00*(2006.01)i; *B23Q 11/00*(2006.01)i
FI:   H01L21/02 D; B03C3/40 A; B03C3/47; B03C3/66; B03C3/60; B23Q11/00 K; B08B6/00

According to International Patent Classification (IPC) or to both national classification and IPC

| B. | FIELDS SEARCHED |
|---|---|

Minimum documentation searched (classification system followed by classification symbols)

H01L21/02; B03C3/40; B03C3/47; B03C3/60; B03C3/66; B08B6/00; B23Q11/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | WO 2011/001978 A1 (CREATIVE TECHNOLOGY CORP.) 06 January 2011 (2011-01-06) paragraphs [0003], [0013], [0025], [0026], [0039], fig. 1, 2 | 1 |
| Y | | 2, 7 |
| A | | 3-6, 8-10 |
| Y | WO 2022/064977 A1 (CREATIVE TECHNOLOGY CORP.) 31 March 2022 (2022-03-31) paragraphs [0002], [0017]-[0023], [0026]-[0029], [0040], fig. 2 | 2, 7 |
| A | JP 2004-158789 A (DENSO CORP.) 03 June 2004 (2004-06-03) entire text, all drawings | 1-10 |

☐ Further documents are listed in the continuation of Box C.          ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **17 October 2023** | **31 October 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/029204**

| Patent document cited in search report | | | Publication date (day/month/year) | Patent family member(s) | | | Publication date (day/month/year) |
|---|---|---|---|---|---|---|---|
| WO | 2011/001978 | A1 | 06 January 2011 | US | 2012/0120545 | A1 | |
| | | | | paragraphs [0004], [0014], [0031]-[0033], [0047], fig. 1, 2 | | | |
| | | | | EP | 2450948 | A1 | |
| | | | | CN | 102473668 | A | |
| | | | | KR | 10-2017-0010105 | A | |
| | | | | KR | 10-2012-0100883 | A | |
| WO | 2022/064977 | A1 | 31 March 2022 | CN | 114555235 | A | |
| | | | | KR | 10-2023-0070168 | A | |
| JP | 2004-158789 | A | 03 June 2004 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022064977 A